# EUROPEAN PATENT SPECIFICATION

(11) **EP 0 366 332 B1**
(45) Date of publication and mention of the grant of the patent: **20.12.1995**
(21) Application number: 89310644.3
(22) Date of filing: 17.10.1989
(51) Int. Cl.: G11C 7/00, G11C 11/419, G11C 7/06

(54) **Digital memory system**
Digitales Speichersystem
Système de mémoire numérique

(30) Priority: 25.10.1988 US 262402
(43) Date of publication of application: 02.05.1990
(73) Proprietor: TEXAS INSTRUMENTS INCORPORATED, Dallas Texas 75265 (US)
(72) Inventor: White, William Alvin, Garland Texas 75043 (US); Taddiken, Albert Henry, McKinney Texas 75069 (US)
(74) Representative: Abbott, David John

(56) References cited:
- EP-A- 0 239 021
- EP-A- 0 243 169
- US-A- 3 900 838
- PATENT ABSTRACTS OF JAPAN vol. 8, no. 23 (P-251)(1460) 21 October 1983 & JP-A- 58 179 990 ( TOKYO SHIBAURA DENKI K.K. ) 15 April 1982
- PATENT ABSTRACTS OF JAPAN vol. 7, no. 206 (P-222)(1351)
- 17 June 1983 & JP- A-58 102 389 ( NIPPON DENSHIN DENWA KOSHA ) 12 December 1981
- PATENT ABSTRACTS OF JAPAN vol. 11, no. 40 (P-544)5 February 1987 & JP-A-61 208 693 ( FUJITSU LIMITED ) 17 September 1986

## Description

The U.S. Government has a paid-up license in this invention and the right in limited circumstances to require the patent owner to license others on reasonable terms as provided for by the terms of Contract No. F33615-85-C-1797 awarded by the Air Force Wright Aeronautical Laboratories.

### FIELD OF THE INVENTION

This invention relates to digital memory systems and, more specifically, to a high speed static random access memory (RAM) system.

### BACKGROUND

In high speed static RAM systems such as, for example, one disclosed in U.S. Patant No. 4,665,508 assigned to the assignee of the present invention, the typical combination of a high bitline capacitance and a relatively low level of bitline charging current necessitates a low bitline voltage swing. Accordingly, conventional static RAM designs have employed relatively complex and power consumptive circuitry to provide sufficient signal magnification. Even so, sense amplifier gain has been a limiting factor in the speed of memory operations, e.g., reading data out of memory cells. That is, for a given level of amplification a minimum bitline swing voltage must be provided in order to develop a signal of sufficient magnitude to permit proper operation of adjoining circuitry.

The response time, t, for developing a voltage swing, V, is proportional to the voltage, i.e.,$\text{V = It/C}$
where I is the bitline charging current and C is the bitline capacitance. The desire in the art is to minimize the response time in order to provide higher speed memory operation. In the process of increasing the density of static RAM devices it is also desirable to minimize power dissipation as well as the area occupied by the circuit components.

In EP-A-0 239 021, there is disclosed a semiconductor memory device having memory cells in a plurality of columns connected to pairs of bitlines. Each bitline receives current from a pullup transistor. Each pair of bitlines is connected through a column transfer gate operated by column address signals to a sense amplifier and to a write circuit including a clamp circuit for clamping a driving level.

In JP-A-58-179990 there is described a sense amplifying circuit having a pair of cross-connected FET's with transistor current sources as loads across which the amplified output signals are developed. The sources and gates of the cross-connected FET's are connected to the outputs of two other FET amplifiers, to the gates of which two lines receiving complementary signals to be amplified are respectively connected.

JP-A-61-208693 discloses a 6-transistor memory cell for a random access memory using MESFET's. Single transistor current sources are respectively connected to two bitlines which are connected to ground through respective diodes, and to which the memory cell is connected through its gate transistors that are controlled by a word line signal.

In accordance with a first aspect of the present invention there is provided a digital memory system comprising: at least a first column of memory cells; a plurality of word lines respectively connected to the memory cells to enable electrical signals to be applied to a selected memory cell; a first bitline connected to each memory cell in the column for electrical signals determining the state of the selected cell; a bitline pullup transistor connectable to a source of electrical power and connected to function as a current source for the bitline and sense amplifying means connected to the bitline to provide an output signal corresponding to the state of the corresponding memory cell characterised in that the sense amplifying means comprises a transistor having its controlled current path connected between the bitline and the bitline pull up transistor 18 to provide at its connection to the bitline pullup transistor a signal corresponding to the state of a selected memory cell; and in that the system further comprises biasing means for biasing the gate of the transistor of the sense amplifying means so that the bias applied is low when the potential on the bitline is high and the bias is high when the potential is low.

In a general form the system includes a column of memory cells and a plurality of word lines connected for selecting a memory cell. A bitline is connected to each memory cell in the column and a bitline pullup transistor having first, second and third terminals is arranged to form a current source at the second terminal. First and second source/drain electrodes of an amplifier transistor are connected to the second terminal of the pullup transistor and the bitline respectively. The gate electrode of the amplifier transistor is connected to receive a bias voltage. An amplified bitline signal corresponding to the state of a selected memory cell is available at an output node between the pullup and amplifier transistors.

The preferred embodiment of the memory system includes first and second bitlines connected to each memory cell in the column. A bitline pullup transistor and an amplifier transistor are associated with each bit line as described above. An output node between the first pullup and amplifier transistors provides an amplified bitline signal corresponding to the state of a selected memory cell while a second output node between the second pullup transistor and the second amplifier transistor provides an amplified bitline signal corresponding to the inverted state of a selected memory cell.

According to a second aspect of the present invention there is provided a digital memory system comprising at least a first column of memory cells, a plurality of word lines respectively connected to the memory cells to enable electrical signals to be applied to a selected memory cell in the first column, first and second bitlines conected to each memory cell in the first column for electrical signals determining the state of the selected memory cell, first and second bitline pullup transistors connectable to a source of electrical power and respectively arranged to provide currents for the first and second bitlines, and sense amplifying means connected to the first and second bitlines for providing at least one output signal corresponding to the state of the selected memory cell, characterised in that the sense amplifying means comprises two transistors, the first transistor having its controlled current path connected between the first bit line pullup transistor and the first bit line and its gate connected to the second bit line, the second transistor having its controlled current path connected between the second bit line pullup transistor and the second bit line and its gate connected to the first bit line; and the at least one output signal is provided at at least one of the connections of the transistors of the sense amplifying means to the bitline pullup transistors.

In accordance with a third aspect of the present invention there is provided a method for enhancing high speed operation of a static random access memory system including at least a first column of memory cells, a plurality of word lines and bitlines connected for memory cell selection, a bitline pullup transistor and a sense amplifier transistor connected to a bitline, the method comprising the steps of feeding a charging current from the bitline pullup transistor to the bitline (BL₁) through the sense amplifier transistor, biasing the gate of the sense amplifier transistor with a low bias when the potential on the bitline is high and with a high bias when the potential on the bitline is low, and deriving a signal corresponding to the state of the selected memory cell from the connection of the sense amplifier transistor to the bitline pullup transistor so as to isolate the capacitance of the bitline (BL₁) from the associated bitline pullup transistor dependent on the low or high bias.

### BRIEF DESCRIPTION OF THE DRAWINGS

The invention may best be understood by reference to the detailed description when read in conjunction with the following drawing, wherein:
Figure 1 provides a partial schematic view of a high speed static RAM device according to the present invention;
Figure 2 illustrates a memory device based on a conventional sense amplifier design;
Figure 3 displays computer simulation results illustrating performance characteristics of a static RAM device constructed according to the invention; and
Figure 4 displays computer simulation results illustrating performance characteristics of a static RAM device based on a conventional sense amplifier design.

Similar reference numbers are used in various figures to designate similar features and components. Certain preferred embodiments of the invention are disclosed herein. However, it should be appreciated that the specific materials, component arrangements and memory sizes disclosed herein are merely illustrative.

### DESCRIPTION OF THE PREFERRED EMBODIMENT

If the bitline current could be used to generate a sufficiently large signal, a simpler, lower power, faster system would be available. However, as already noted, the speed requirements of high density memories preclude obtaining the full amplitude signal directly from the bitlines. According to the present invention a merged bitline pullup - sense amplifier circuit provides an impedance transformation, i.e., a current to voltage conversion of the bitline signal. This results in a highly amplified voltage output signal indicative of the state of a selected memory cell.

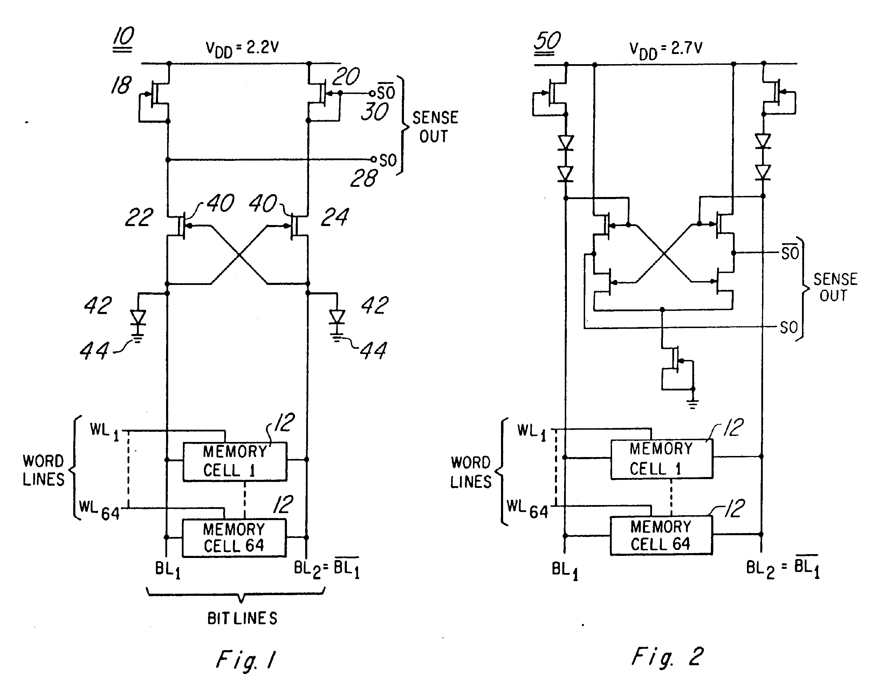

Figure 1 is a partial schematic view of a high speed static RAM device 10 comprising a merged bitline pullup - sense amplifier circuit in conjunction with an exemplary column of 64 memory cells 12. Although the device 10 is presented in simplified form to more clearly describe the invention, it is to be understood that the device includes numerous additional components present in conventional static RAM architecture such as row and column address circuitry, decode logic and output circuitry. See U.S. Patent No. 4,665,508.

By way of illustration, the device 10 may be a 4K GaAs MESFET Static RAM containing 4,096 memory cells organized in a 64 row by 64 column array. Decoding may be implemented with a single level of 64 six-input NOR gates. The decoded 6-bit row and column addresses enable the word lines and select a particular column of memory cells. Data are sequentially written into or read out of selected memory cells in accordance with the state of the write enable, data in and chip select signals.

The memory cells 12 illustrated in Figure 1 may each be, for example, of a conventional six transistor design including two cross-coupled switching transistors, two load transistors and a pair of pass transistors. A plurality of word lines WLᵢ and bitlines BLᵢ are connected for memory cell selection. As illustrated in Figure 1, bitlines BL₁ and BL₂ are coupled to the memory cells 12 along opposing sides of the column. The bitlines are coupled to a power supply line V_{DD} by bitline pullup - sense amplifier circuitry which includes a pair of dual function pullup/load transistors 18 and 20 as well as a pair of amplifier transistors 22 and 24 each positioned between a bitline and one of the dual function transistors 18 or 20.

An amplifier output node 28 or 30 is located between each dual function transistor 18 or 20 and an adjacent amplifier transistor 22 or 24. The amplifier transistors 22 and 24 are positioned to isolate the bitline capacitance from the output nodes 28 and 30. With this isolation each transistor 18 and 20 serves as the load to an adjacent amplifier transistor. The arrangement enables a very fast amplified output to be developed at the output nodes 28 and 30.

As a minimum the circuit only requires four devices to perform both bitline charging and amplification of the otherwise low level bitline signals. In the preferred embodiment the gate electrode 40 of each amplifier transistor 22 and 24 is connected to an opposing bitline and all four transistors 18, 20, 22 and 24 are depletion mode MESFETs. The transistors 18 and 20 are each arranged with the drain electrode coupled to V_{DD} and the gate tied to the source electrode thereby providing a current source. To further limit the high level of the bitline swing voltage, a clamping diode 42 may be serially connected between each bitline and a reference potential 44.

A computer simulation has been carried out to compare the performance of the device 10 with the memory device 50 of Figure 2, which is based on a conventional sense amplifier design. The device 50 also includes the clamping diodes 42 of the present invention in order to obtain similar voltage swings, this permitting a more objective evaluation of the merged bitline - pullup circuitry of the present invention. The comparison was performed by reading data out of two adjacent memory cells 12 in a column.

The adjacent cells were initialized to opposite states in order to require reversal of voltages in bitlines BL₁ and BL₂. That is, simultaneously switching WL₁ and WL₂ reverses the memory cell selection and causes the bitlines to charge to opposite states. The bitlines were assumed to each include 0.3 pF of capacitance.

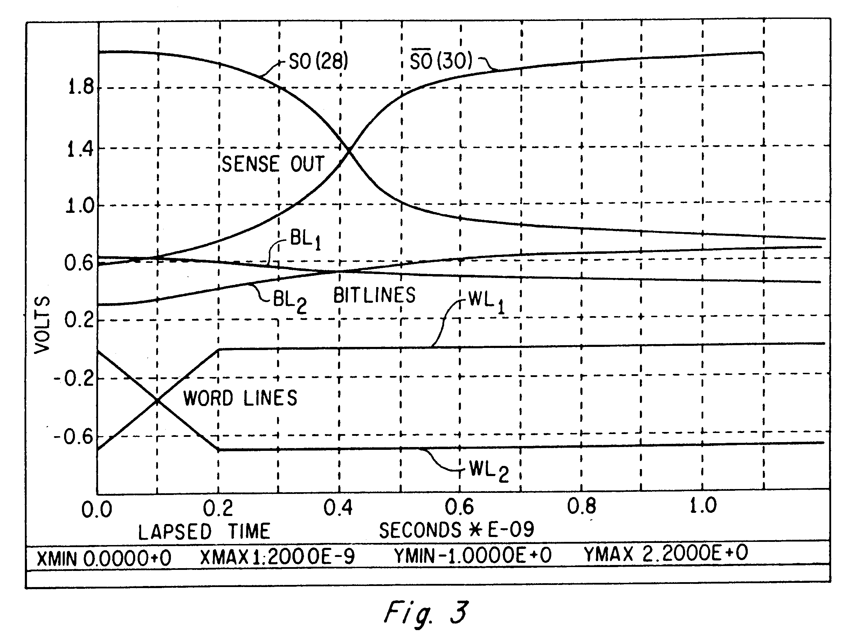

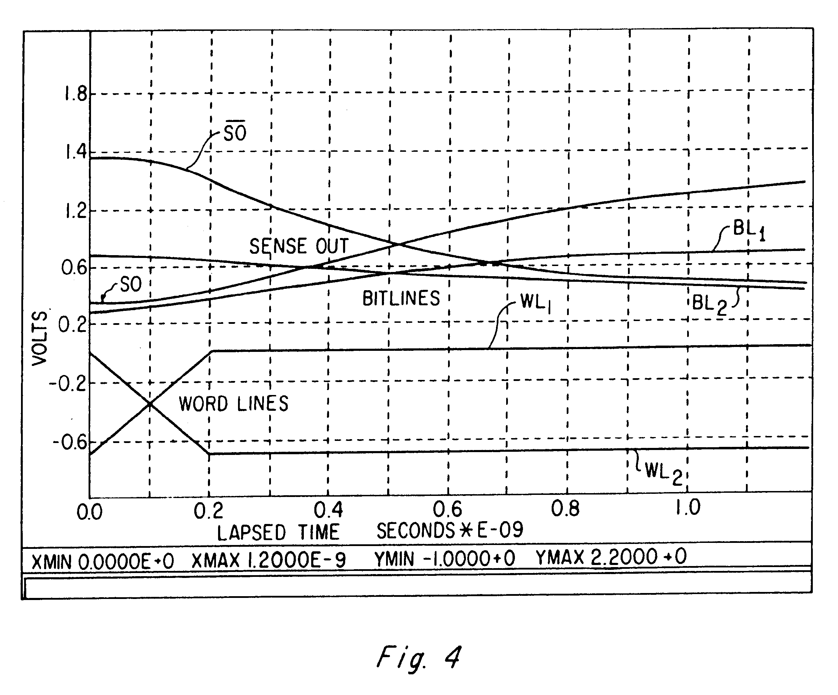

The simulation results based on the designs of devices 10 and 50 are illustrated in Figures 3 and 4, respectively. In each case the voltage changes in the bitlines BL₁ and BL₂ and the word linear WL₁ and WL₂ are plotted along with the amplified Sense Out waveforms SO.

The output waveforms of the device 10, designated in Figure 3 as SO(28) and S̅O̅(30), exhibit faster and more symmetrical rise and fall times than those of the device 50. For example, lapsed time between the word line and sense out cross points is approximately 0.1 ns shorter for the device 10. The rise time of the device 10 sense out signal, e.g., to 90 percent of the peak to peak value, is also much shorter. Furthermore, in modeling the response time V_{DD} for device 50 was 2.7 volts while V_{DD} for the device 10 was only 2.2 volts. Nevertheless, the output signal of the device 10 was much larger, i.e., approximately 0.5 volts.

The combination of faster rise time and higher gain provide a relatively larger output signal for a given response time. Thus the device 10 is capable of providing output signals of acceptable magnitude faster than the device 50. For example, the device 10 provides a sense out signal of 0.5 volts (as measured from the sense out cross points) in approximately 0.1 ns. In comparison, the device 50 requires greater than a 0.5 ns rise time to develop a 0.5 volt output. Thus higher speed memory operation is attainable with the merged bitline - pullup circuitry of the present invention.

A corresponding method for enhancing high speed static random access memory operation comprises the step of isolating the capacitance of a bitline from the associated bitline pullup device. In a preferred form the pullup device is positioned to function as the sense amplifier load as well as the bitline current source. The result is faster and simpler memory operation.

### ADVANTAGES AND MODIFICATIONS

A feature of the preferred embodiment circuit 10 is that the gate electrode 40 of each amplifier transistor 22 and 24 is connected to an opposing bitline. Although the gate bias of each amplifier transistor could be provided with a DC voltage, the cross coupled scheme of Figure 1 is advantageous for three reasons. First, the coupling eliminates the need for providing an external voltage bias. Second, the amplified signal response times at the output nodes 28 and 30 are nearly symmetrical in comparison to the bitline response. Third, the amplifier sensitivity is approximately doubled because the gate to source voltage of each amplifier transistor is essentially the difference between the two bitline voltages.

In addition to requiring fewer components than conventional memory devices, the designs disclosed herein are more power efficient because the same current that charges the bitlines provides the output signal through a simple impedance transformation.

In alternative embodiments of the invention a single bitline, e.g., BL₁, in combination with one pullup/load transistor 18 and one amplifier transistor 22 provide sufficient gain for RAM operation although a longer response time may be required in order to develop a desired sense out voltage response. The advantages of this embodiment are lower power dissipation and fewer components.

Certain embodiments of the invention have been described. Various other arrangements and configurations of the disclosed embodiments and components thereof will be apparent. For example, while GaAs components may be preferred for high speed operation, other semiconductor materials such as silicon are applicable. To realize advantages of the design principles disclosed herein semiconductor components are not required.

While it is preferred that the transistors 18, 20, 22 and 24 be of equal size, this is not necessary. Nor do the transistors have to be MESFETs. They may, for example, be replaced with MOS, bipolar or other types of devices. All of the devices 18 - 24 could be high electron mobility transistors (HEMTs). Furthermore, designs incorporating enhancement mode devices are within the scope of substitutions, although these may not provide satisfactory performance. Accordingly, the scope of the invention is only to be limited by the claims which follow.

## Claims

1. A digital memory system comprising: at least a first column of memory cells (12); a plurality of word lines (WL) respectively connected to the memory cells to enable electrical signals to be applied to a selected memory cell; a first bitline (BL1) connected to each memory cell in the column for electrical signals determining the state of the selected cell; a bitline pullup transistor (18) connectable to a source of electrical power and connected to function as a current source for the bitline; and sense amplifying means connected to the bitline to provide an output signal corresponding to the state of the corresponding memory cell characterised in that the sense amplifying means comprises a transistor (22) having its controlled current path connected between the bitline and the bitline pull up transistor (18) to provide at its connection to the bitline pullup transistor a signal corresponding to the state of a selected memory cell; and in that the system further comprises biasing means for biasing the gate of the transistor of the sense amplifying means so that the bias applied is low when the potential on the bitline is high and the bias is high when the potential is low.

2. A digital memory system comprising at least a first column of memory cells (12), a plurality of word lines (WL) respectively connected to the memory cells to enable electrical signals to be applied to a selected memory cell (12) in the first column, first and second bitlines (BL1,BL2) connected to each memory cell (12) in the first column for electrical signals determining the state of the selected memory cell (12), first and second bitline pullup transistors (18,20) connectable to a source of electrical power and respectively arranged to provide currents for the first and second bitlines (BL1,BL2), and sense amplifying means (22,24) connected to the first and second bitlines (BL1,BL2) for providing at least one output signal corresponding to the state of the selected memory cell (12), characterised in that the sense amplifying means comprises two transistors (22, 24), the first transistor (22) having its controlled current path connected between the first bit line pullup transistor (18) and the first bit line (BL1) and its gate (40) connected to the second bit line (BL2), the second transistor (24) having its controlled current path connected between the second bit line pullup transistor (20) and the second bit line (BL2) and its gate (40) connected to the first bit line (BL1); and the at least one output signal is provided at least at one of the connections of the transistors of the sense amplifying means to the bitline pullup transistors.

3. A system according to claim 1 or claim 2 characterised in that the or each pullup transistor (18,20) is a field effect transistor with its source or drain electrode connected to its gate electrode.

4. A system according to any one of claims 1, 2 and 3 characterised in that the or each transistor of the sense amplifying means has source and drain terminals connected to the ends of a channel forming its controlled current path and a gate as the control electrode for controlling that current.

5. A system according to any one of the preceding claims characterised in that the or each bitline pullup transistor acts as the load for the corresponding transistor of the sense amplifying means.

6. A system according to any one of the preceding claims, characterised in that the or each bitline (BL₁,BL₂) includes a terminal connectable to a reference potential; there being provided for the or each bitline a diode (42) serially connected between the terminal of the bitline and the reference potential.

7. A system according to any one of the preceding claims, characterised in the pullup transistor (18,20) and the first or second transistor (22,24) are gallium arsenide MESFETs.

8. A system according to any one of the preceding claims, characterised in that the memory cells are static random access memory cells.

9. A method for enhancing high speed operation of a static random access memory system including at least a first column of memory cells (12), a plurality of word lines (WL) and bitlines (BL) connected for memory cell selection, a bitline pullup transistor (18) and a sense amplifier transistor (22) connected to a bitline (BL₁), said method comprising the steps of
feeding a charging current from the bitline pullup transistor (18) to the bitline (BL₁) through the sense amplifier transistor (22),
biasing the gate of the sense amplifier transistor with a low bias when the potential on the bitline is high and with a high bias when the potential on the bitline is low, and
deriving a signal corresponding to the state of the selected memory cell from the connection of the sense amplifier transistor to the bitline pullup transistor so as to isolate the capacitance of the bitline (BL₁) from the associated bitline pullup transistor (18) dependent on the low or high bias.

10. A method according to claim 9, characterised in that in the step of feeding the charging current to the bitline is accomplished by connecting the bitline pullup transistor (18) so as to function as the load of the sense amplifier transistor (22) as well as the bitline current source.

11. A method according to claim 9, wherein the step of feeding the charging current to the bitline is accomplished by connecting the sense amplifier transistor (22) in series between the bitline pullup transistor (18) and the bitline (BL₁).

12. A method according to any of claims 9 to 11, in which the sense amplifier transistor (22) is an FET and the method is applied to the system further having a second bitline (BL₂) associated to the first column of memory cells for memory cell state signals, a second bitline pullup transistor (20) and a second sense amplifier transistor (24), connected between the second bit line pull up transistor and the second bit line, and wherein the gate of the first sense amplifier transistor (22) is connected to the second bitline (BL₂) and the gate of the second sense amplifier transistor (24) is connected to the first bitline (BL₁).

## Patentansprüche

1. Digitales Speichersystem mit wenigstens einer ersten Spalte aus Speicherzellen (12); mehreren Wortleitungen (WL), die jeweils an die Speicherzellen angeschlossen sind, um an eine ausgewählte Speicherzelle anzulegende elektrische Signale freizugeben; einer ersten, an jede Speicherzelle in der Spalte angeschlossenen Bitleitung (BL1) für elektrische Signale, die den Zustand der ausgewählten Zelle bestimmen; einem Bitleitungs-Pullup-Transistor (18), der an eine Quelle elektrischer Energie anschließbar ist und so angeschlossen ist, daß er als Stromquelle für die Bitleitung wirkt; und Leseverstärkermitteln, die an die Bitleitung angeschlossen sind, um ein dem Zustand der entsprechenden Speicherzelle entsprechendes Ausgangssignal zu liefern, dadurch gekennzeichnet, daß die Leseverstärkermittel einen Transistor (22) enthalten, dessen gesteuerter Strompfad zwischen der Bitleitung und dem Bitleitungs-Pullup-Transistor (18) liegt, damit an seiner Verbindungsstelle mit dem Bitleitungs-Pullup-Transistor ein dem Zustand einer ausgewählten Speicherzelle entsprechendes Signal geliefert wird; und daß das System ferner Vorspannungsmittel enthält, die den Gate-Anschluß des Transistors der Leseverstärkermittel vorspannen, daß die angelegte Vorspannung niedrig ist, wenn das Potential an der Bitleitung hoch ist und die Vorspannung hoch ist, wenn das Potential niedrig ist.

2. Digitales Speichersystem mit wenigstens einer ersten Spalte aus Speicherzellen (12), mehreren Wortleitungen (WL), die jeweils an die Speicherzellen angeschlossen sind, um an eine ausgewählte Speicherzelle (12) in der ersten Spalte anzulegende elektrische Signale freizugeben, mit jeder Speicherzelle (12) in der ersten Spalte verbundenen ersten und zweiten Bitleitungen (BL1, BL2) für elektrische Signale, die den Zustand der ausgewählten Speicherzelle (12) bestimmen, ersten und zweiten Bitleitungs-Pullup-Transistoren (18, 20), die an eine Quelle elektrischer Energie anschließbar sind und jeweils so angeordnet sind, daß sie Ströme für die ersten und zweiten Bitleitungen (BL1, BL2) liefern, und Leseverstärkermitteln (22, 24), die mit den ersten und zweiten Bitleitungen (BL1, BL2) verbunden sind, um wenigstens ein den Zustand der ausgewählten Speicherzelle (12) entsprechendes Ausgangssignal zu liefern, dadurch gekennzeichnet, daß die Leseverstärkermittel zwei Transistoren (22, 24) enthalten, wobei der gesteuerte Strompfad des ersten Transistors (22) zwischen dem ersten Bitleitungs-Pullup-Transistor (18) und der ersten Bitleitung (BL1) liegt, während sein Gate-Anschluß (40) mit der zweiten Bitleitung (BL2) verbunden ist, und wobei der gesteuerte Strompfad des zweiten Transistors (24) zwischen dem zweiten Bitleitungs-Pullup-Transistor (20) und der zweiten Bitleitung (BL2) liegt, während sein Gate-Anschluß (40) mit der ersten Bitleitung (BL1) verbunden ist; und daß das wenigstens eine Ausgangssignal wenigstens an einem der Verbindungspunkte der Transistoren der Leseverstärkermittel mit den Bitleitungs-Pullup-Transistoren geliefert wird.

3. System nach Anspruch 1 oder 2, dadurch gekennzeichnet, daß jeder Pullup-Transistor (18, 20) ein Feldeffekttransistor ist, dessen Source- oder Drain-Elektrode mit seiner Gate-Elektrode verbunden ist.

4. System nach einem der Ansprüche 1, 2 und 3, dadurch gekennzeichnet, daß der oder jeder Transistor der Leseverstärkermittel Source- und Drain-Anschlüsse aufweist, die mit den Enden eines Kanals verbunden sind, der seinen gesteuerten Stromweg bildet, und ferner als Steuerelektrode einen Gate-Anschluß zum Steuern dieses Stroms aufweist.

5. System nach einem der vorhergehenden Ansprüche, dadurch gekennzeichnet, daß der oder jeder Bitleitungs-Pullup-Transistor als Last für den entsprechenden Transistor der Leseverstärkermittel wirkt.

6. System nach einem der vorhergehenden Ansprüche, dadurch gekennzeichnet, daß die oder jede Bitleitung (BL1, BL2) eine an ein Referenzpotential anlegbare Klemme enthält, wobei für jede Bitleitung eine Diode (42) vorgesehen ist, die seriell zwischen der Klemme der Bitleitung und dem Referenzpotential liegt.

7. System nach einem der vorhergehenden Ansprüche, dadurch gekennzeichnet, daß der Pullup-Transistor (18, 20) und der erste oder der zweite Transistor (22, 24) Galliumarsenid-MES-Feldeffekttransistoren sind.

8. System nach einem der vorhergehenden Ansprüche, dadurch gekennzeichnet, daß die Speicherzellen statische Schreib/Lese-Speicherzellen sind.

9. Verfahren zum Verbessern des Hochgeschwindigkeitsbetriebs eines statischen Schreib/Lese-Speichersystems mit wenigstens einer ersten Spalte aus Speicherzellen (12), mehreren Wortleitungen (WL) und Bitleitungen (BL), die für die Speicherzellenauswahl angeschlossen sind, einem Bitleitungs-Pullup-Transistor (18) und einem Leseverstärkertransistor (22), die an eine Bitleitung (BL1) angeschlossen sind, wobei das Verfahren die Schritte enthält
Zuführen eines Ladestroms aus dem Bitleitungs-Pullup-Transistor (18) zu der Bitleitung (BL1) durch den Leseverstärkertransistor (22),
Vorspannen des Gate-Anschlusses des Leseverstärkertransistors mit einer niedrigen Vorspannung, wenn das Potential an der Bitleitung hoch ist, und mit einer hohen Vorspannung, wenn das Potential an der Bitleitung niedrig ist, und
Ableiten eines dem Zustand der ausgewählten Speicherzelle entsprechenden Signals vom Verbindungspunkt des Leseverstärkertransistors mit dem Bitleitungs-Pullup-Transistor, so daß die Kapazität der Bitleitung (BL1) abhängig von der niedrigen oder hohen Vorspannung von dem zugehörigen Bitleitungs-Pullup-Transistor (18) entkoppelt wird.

10. Verfahren nach Anspruch 9, dadurch gekennzeichnet, daß der schritt des Zuführens des Ladestroms zu der Bitleitung dadurch erzielt wird, daß der Bitleitungs-Pullup-Transistor (18) so angeschlossen wird, daß er als Last des Leseverstärkertransistors (22) und als Bitleitungs-Stromquelle wirkt.

11. Verfahren nach Anspruch 9, bei welchem der Schritt des Zuführens des Ladestroms zur Bitleitung dadurch erzielt wird, daß der Leseverstärkertransistor (22) in Serie zwischen den Bitleitungs-Pullup-Transistor (18) und die Bitleitung (BL1) eingefügt wird.

12. Verfahren nach einem der Ansprüche 9 bis 11, bei welchem der Leseverstärkertransistor (22) ein Feldeffekt-Transistor ist und das Verfahren auf das System angewendet wird, das außerdem eine zweite Begleitung (BL2) enthält, die der ersten Spalte aus Speicherzellen für Speicherzellen-Zustandssignale zugeordnet ist, einen zweiten Bitleitungs-Pullup-Transistor (20) und einen zweiten Leseverstärkertransistor (24) enthält, der zwischen dem zweiten Bitleitungs-Pullup-Transistor und der zweiten Bitleitung liegt, wobei der Gate-Anschluß des ersten Leseverstärkertransistors (22) mit der zweiten Bitleitung (BL2) verbunden ist und der Gate-Anschluß des zweiten Leseverstärkertransistors (24) mit der ersten Bitleitung (BL1) verbunden ist.

## Revendications

1. Système de mémoire numérique comprenant : au moins une première colonne de cellules de mémoire (12); une pluralité de lignes de transmission de mots (WL) raccordées respectivement aux cellules de mémoire pour permettre l'application de signaux électriques à une cellule de mémoire sélectionnée; une première ligne de transmission de bits (BL1) connectée à chaque cellule de mémoire de la colonne pour des signaux électriques déterminant l'état de la cellule sélectionnée; un transistor élévateur (18) de la ligne de transmission de bits, pouvant être raccordé à une source d'énergie électrique et connecté de manière à fonctionner en tant que source de courant pour la ligne de transmission de bits; et des moyens amplificateurs de détection raccordés à la ligne de transmission de bits pour délivrer un signal de sortie correspondant à l'état de la cellule de mémoire correspondante, caractérisé en ce que les moyens amplificateurs de détection comprennent un transistor (22), dont la voie de courant commandée est branchée entre la ligne de transmission de bits et le transistor élévateur (18) de la ligne de transmission de bits pour délivrer, au niveau de sa connexion avec le transistor élévateur de la ligne de transmission de bits, un signal correspondant à l'état d'une cellule de mémoire sélectionnée; et en ce que le système comporte en outre des moyens de polarisation pour polariser la grille du transistor des moyens amplificateurs de détection de telle sorte que la polarisation appliquée est faible lorsque le potentiel de la ligne de transmission de bits est haut et que la polarisation est élevée lorsque le potentiel est bas.

2. Système de mémoire numérique comprenant au moins une colonne de cellules de mémoire (12), une pluralité de lignes de transmission de mots (WL) connectées respectivement aux cellules de mémoire pour permettre l'application de signaux électriques à la cellule de mémoire sélectionnée (12) dans la première colonne, des première et seconde lignes de transmission de bits (BL1,BL2) connectées à chaque cellule de mémoire (12) de la première colonne pur des signaux électrique déterminant l'état de la cellule de mémoire sélectionnée (12); des transistors élévateurs (18,20) des première et seconde lignes de transmission de bits, qui peuvent être connectés à une source d'énergie électrique et sont disposés respectivement de manière à délivrer des courants pour les première et seconde lignes de transmission de bits (BL1, BL2), et des moyens amplificateurs de détection (22,24) connectés au première et seconde lignes de transmission de bits (BL1,BL2) pour délivrer au moins un signal de sortie correspondant à l'état de la cellule de mémoire sélectionnée (12), caractérisé en ce que les moyens amplificateurs de détection comprennent deux transistors (22,24), la voie de courant commandée du transistor (22) étant branchée entre le transistor élévateur (18) de la première ligne de transmission de bits et la première ligne de transmission de bits (BL1), tandis que sa grille (40) est connectée à la seconde ligne de transmission de bits (BL2), alors que la voie de courant commandée du second transistor (24) est branchée entre le transistor élévateur (20) de la seconde ligne de transmission de bits et cette seconde ligne de transmission de bits (BL2) et que sa grille (40) est connectée à la première ligne de transmission de bits (BL1); et le au moins un signal de sortie est appliqué, dans au moins l'une des connexions des transistors des moyens amplificateurs de détection aux transistors élévateurs des lignes de transmission de bits.

3. Système selon la revendication 1 ou 2, caractérisé en ce que le ou chaque transistor élévateur (18,20) est un transistor à effet de champ, dont les électrodes de source et de drain sont connectées à son électrode de grille.

4. Système selon l'une quelconque des revendications 1,2 et 3, caractérisé en ce que le ou chaque transistor des moyens amplificateurs de détection possède des bornes de source et de drain connectées aux extrémités d'un canal formant sa voie de courant commandée, et une grille en tant qu'électrode de commande pour commander ce courant.

5. Système selon l'une quelconque des revendications précédentes, caractérisé en ce que le ou chaque transistor élévateur des lignes de transmission de bits agit en tant que charge pour le transistor correspondant des moyens amplificateurs de détection.

6. Système selon l'une quelconque des revendications précédentes, caractérisé en ce que la ou chaque ligne de transmission de bits (BL₁, BL₂) comprend une borne pouvant être connectée à un potentiel de référence; et pour la ou chaque ligne de transmission de bits il est prévu une diode (42) branchée en série entre la borne de la ligne de transmission de bits et le potentiel de référence.

7. Système selon l'une quelconque des revendications précédentes, caractérisé en ce que le transistor élévateur (18,20) et le premier ou le second transistor (24) sont des transistors MESFET à arséniure de gallium.

8. Système selon l'une quelconque des revendications précédentes, caractérisé en ce que les cellules de mémoire sont des cellules de mémoire statique à accès direct.

9. Procédé pour améliorer le fonctionnement à grande vitesse d'un système de mémoire statique à accès direct comprenant au moins une première colonne de cellules de mémoire (12), une pluralité de lignes de transmission de mots (WL) et de lignes de transmission de bits (BL) connectées pour la sélection de cellules de mémoire, un transistor élévateur (18) d'une ligne de transmission de bits et un transistor amplificateur de détection (22) connectés à une ligne de transmission de bits (BL₁), ledit procédé consistant à :
envoyer un courant de charge depuis le transistor élévateur (18) de la ligne de transmission de bits (BL₁) à cette ligne de transmission de bits par l'intermédiaire du transistor amplificateur de détection (22),
polariser la grille du transistor amplificateur de détection avec une fiable polarisation lorsque le potentiel dans la ligne de transmission est élevé, et avec une polarisation élevée lorsque le potentiel dans la ligne de transmission de bits est faible, et
dériver un signal correspondant à l'état de la cellule de mémoire sélectionnée à partir de la connexion du transistor amplificateur de détection au transistor élévateur de la ligne de transmission de bits de manière à isoler la capacité de la ligne de transmission de bits (BL₁) par rapport au transistor élévateur associé (18) de la ligne de transmission de bits, en fonction de la polarisation faible ou élevée.

10. Procédé selon la revendication 9, caractérisé en ce que l'étape d'envoi du courant de charge à la ligne de transmission de bits est réalisée par raccordement du transistor élévateur (18) de la ligne de transmission de bits de manière qu'il fonctionne en tant que charge du transistor amplificateur de détection (22) ainsi qu'en tant que source de courant de la ligne de transmission de bits.

11. Procédé selon la revendication 9, dans lequel l'étape d'envoi du courant de charge à la ligne de transmission de bits est réalisée au moyen du branchement du transistor amplificateur de détection (22) en série entre le transistor élévateur (18) de la ligne de transmission de bits et la ligne de transmission de bits (BL₁).

12. Procédé selon l'une quelconque des revendications 9 à 11, dans lequel le transistor amplificateur de détection (22) est un transistor FET, et le procédé est appliqué au système comportant en outre une seconde ligne de transmission de bits (BL₂) associée à la première colonne de cellules de mémoire pour des signaux d'état des cellules de mémoire, un transistor élévateur (20) de la seconde ligne de transmission de bits et un transistor amplificateur de détection (24) branché entre le transistor élévateur de la seconde ligne de transmission de bits et cette seconde ligne de transmission de bits, la grille du premier transistor amplificateur de détection (22) étant connectée à la seconde ligne de transmission de bits (BL₂) et la grille du second transistor amplificateur de détection (24) étant connectée à la première ligne de transmission de bits (BL₁).
